(19) Europäisches Patentamt / European Patent Office / Office européen des brevets

(11) **EP 4 444 820 B1**

(12) **EUROPEAN PATENT SPECIFICATION**

(45) Date of publication and mention
of the grant of the patent:
**25.02.2026 Bulletin 2026/09**

(21) Application number: **22826744.9**

(22) Date of filing: **10.11.2022**

(51) International Patent Classification (IPC):
*C09K 11/63* (2006.01)  *C09K 11/64* (2006.01)
*C09K 11/59* (2006.01)

(52) Cooperative Patent Classification (CPC):
**C09K 11/77347; C09K 11/77928**

(86) International application number:
**PCT/US2022/049598**

(87) International publication number:
**WO 2023/107239 (15.06.2023 Gazette 2023/24)**

(54) **NITRIDOBSILICATE PHOSPHORS**

NITRIDOSILIKAT-LEUCHTSTOFFE

LUMINOPHORES DE NITRIDOSILICATE

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**

(30) Priority: **09.12.2021 US 202163287797 P**

(43) Date of publication of application:
**16.10.2024 Bulletin 2024/42**

(73) Proprietor: **Lumileds LLC**
**San Jose, CA 95131 (US)**

(72) Inventors:
• **GIFTTHALER, Tobias**
**80539 Muenchen (DE)**
• **STROBEL, Philipp-Jean**
**52068 Aachen (DE)**
• **SCHMIDT, Peter Josef**
**52068 Aachen (DE)**
• **BECHTEL, Hans-Helmut**
**52068 Aachen (DE)**
• **SCHNICK, Wolfgang**
**80539 Muenchen (DE)**

(74) Representative: **Cohausz & Florack**
**Patent- & Rechtsanwälte**
**Partnerschaftsgesellschaft mbB**
**Bleichstraße 14**
**40211 Düsseldorf (DE)**

(56) References cited:
**US-A1- 2010 224 895    US-A1- 2010 277 054**
**US-A1- 2011 227 475**

**Description**

CROSS-REFERENCE TO RELATED APPLICATIONS

This application claims benefit of priority to U.S. Provisional Patent Application Number 63/287,797 filed December 9, 2021.

FIELD OF THE INVENTION

The invention relates generally to pcLEDs, pcLED arrays, light sources comprising pcLEDs or pcLED arrays, and displays comprising pcLED arrays.

BACKGROUND

Semiconductor light emitting diodes and laser diodes (collectively referred to herein as "LEDs") are among the most efficient light sources currently available. The emission spectrum of an LED typically exhibits a single narrow peak at a wavelength determined by the structure of the device and by the composition of the semiconductor materials from which it is constructed. By suitable choice of device structure and material system, LEDs may be designed to operate at ultraviolet, visible, or infrared wavelengths.

LEDs may be combined with one or more wavelength converting materials (generally referred to herein as "phosphors") that absorb light emitted by the LED and in response emit light of a longer wavelength. For such phosphor-converted LEDs ("pcLEDs"), the fraction of the light emitted by the LED that is absorbed by the phosphors depends on the amount of phosphor material in the optical path of the light emitted by the LED, for example on the concentration of phosphor material in a phosphor layer disposed on or around the LED and the thickness of the layer. Phosphor-converted LEDs may be designed so that all the light emitted by the LED is absorbed by one or more phosphors, in which case the emission from the pcLED is entirely from the phosphors. In such cases the phosphor may be selected, for example, to emit light in a narrow spectral region that is not efficiently generated directly by an LED. Alternatively, pcLEDs may be designed so that only a portion of the light emitted by the LED is absorbed by the phosphors, in which case the emission from the pcLED is a mixture of light emitted by the LED and light emitted by the phosphors. By suitable choice of LED, phosphors, and phosphor composition, such a pcLED may be designed to emit, for example, white light having a desired color temperature and desired color-rendering properties.

Technological and business applications of pcLEDs include use in displays, matrices and light engines including automotive adaptive headlights, augmented-reality (AR) displays, virtual-reality (VR) displays, mixed-reality (MR) displays, smart glasses and displays for mobile phones, smart watches, monitors and TVs, and flash illumination for cameras in mobile phones. The individual LED pixels in these architectures can have an area of a few square millimeters down to a few square micrometers depending on the matrix or display size and its pixel per inch requirements. LED matrices/displays may for example be realized by transfer and attachment of individual pixels from a donor substrate to a controller backplane or electronic board or be created by a monolithic approach where a monolithically integrated array of LED pixels is processed into an LED module on a donor epitaxial wafer and then transferred and attached to a controller backplane.

Backlights for liquid crystal-displays typically employ pcLEDs comprising a combination of green and red phosphors. To realize a large color gamut, it is important to have a green phosphor with a FWHM as small as possible. Eu-doped beta-SiAlON is a green phosphor widely applied in display technology. Another narrow-band green emitting phosphor that is discussed for display application is $SrSi_2O_2N_2$:Eu.

Known issues of beta-SiAlONs are low blue light absorption, limited by a low Eu concentration that can be incorporated by the lattice, concentration quenching with higher Eu concentrations, and reliability issues for emission in the dark green spectral range. Other narrow-band green emitters, such as $SrSi_2O_2N_2$:Eu, exhibit low photothermal stability and reliability under application conditions.

US 2010/277054 A1 discloses a light emitting device having a wavelength converting member for absorbing light from a pumping light source and converting its wavelength.

SUMMARY

This specification discloses nitridosilicate photoluminescent compositions (i.e., phosphors) characterized by the formula

$$AE_{1-x-y-u}A_{y+u}Be_{1-y-z-v}B_{y+z+v}Si_{1-z}Al_zO_{1-v}N_{2+v}:Eu_x,Ce_u,$$

where AE = Ba, Sr, Ca, Mg; A = Li, Na, K, Rb; $0 \leq x \leq 0.1$; $0 \leq u \leq 0.1$; $0 < (x + u)$; $0 \leq y \leq 1$; $0 \leq z \leq 1$; $(y + z + v) \leq 1$; and $(x + y + u) \leq$

1.

Members of this family of phosphors (e.g., $Ba_{1-x}BeSiON_2:Eu_x$) may crystallize in an orthorhombic crystal structure for example and may for example emit narrow band green light upon excitation with blue or shorter wavelength light. Peak emission may be in the range 520 nm to 530 nm with a full width at half maximum of less than or equal to 50 nm, or less than or equal to 45 nm, for example. More generally, peak emission may be in the range 500 nm to 560 nm, with a full width at half maximum of less than or equal to 55 nm, for example.

The substitution of Be by B ( i.e., y +z + v > 0) may lead to a blue shift of absorption and emission bands due to the reduced charge density of O ligands surrounding the activator ions (Eu, Ce).

A combined doping of [B,Al] for [Be,Si] (i.e., z > 0) may improve the chemical stability of the host lattice.

Ce will emit in the blue spectral range and may help to improve the photostability of the Eu(II) emission if added as co-dopant (i.e., . x > 0 and u > 0.).

Co-doping with monovalent alkaline atoms (i.e., y + u > 0) may improve grain growth due to the formation of reactive intermediate products.

Examples of this family of phosphors include:

$$Ba_{0.9}Sr_{0.05}K_{0.015}Be_{0.5}B_{0.5}Si_{0.5}Al_{0.5}ON_2:Eu_{0.02},$$

$$Ce_{0.015}, Ba_{0.48}Na_{0.5}Be_{0.5}B_{0.5}SiON_2:Eu_{0.02}, Ba_{0.5}Sr_{0.49}Be_{0.5}B_{0.5}SiO_{0.5}N_{2.5}:Eu_{0.01},$$

$$Sr_{0.99}BSiN_3:Eu_{0.01}.$$

Further examples of this family of phosphors include $Ba_{1-x}BeSiON_2:Eu_x$, where:
$0 < x \leq 0.10$, or $0 < x \leq 0.04$, or $0.005 \leq x \leq 0.02$, or x = 0.005, or x = 0.0075, or x = 0.01, or x= 0.02, for example.

This specification also discloses light emitting devices comprising a light emitting diode that emits primary light and a nitridosilicate phosphor as characterized above, for example, arranged in an optical path of light output from the light emitting diode to absorb primary light and in response emit secondary light having a longer wavelength than the primary light.

The phosphors and phosphor converted LEDs disclosed herein may be used for example in the various devices and applications listed above in the Background section.

These and other embodiments, features and advantages of the present invention will become more apparent to those skilled in the art when taken with reference to the following more detailed description of the invention in conjunction with the accompanying drawings that are first briefly described

BRIEF DESCRIPTION OF THE DRAWINGS

Figure 1 shows a schematic cross-sectional view of an example pcLED.

Figures 2A and 2B show, respectively, cross-sectional and top schematic views of an array of pcLEDs.

Figure 3A shows a schematic top view of an electronics board on which an array of pcLEDs may be mounted, and Figure 3B similarly shows an array of pcLEDs mounted on the electronic board of Figure 3A.

Figure 4A shows a schematic cross-sectional view of an array of pcLEDs arranged with respect to waveguides and a projection lens. Figure 4B shows an arrangement similar to that of Figure 4A, without the waveguides.

Figure 5 schematically illustrates an example camera flash system comprising an adaptive illumination system.

Figure 6 schematically illustrates an example display (e.g., AR/VR/MR) system that includes an adaptive illumination system.

Figure 7 shows the crystal structure of $BaBeSiON_2$.

Figure 8 shows a measured XRD powder pattern (molybdenum radiation) for the material prepared in Example 1.

Figure 9 shows an excitation spectrum (dashed line) and an emission spectrum (solid line) for the material prepared in Example 1.

Figure 10 shows thermal quenching behavior for the material prepared in Example 1.

Figure 11 shows excitation spectra (dashed lines) and emission spectra (solid lines) for the series of materials prepared in Example 2.

Figure 12 shows an excitation spectrum (dashed line) and an emission spectrum (solid line) for the material prepared in Example 3.

Figure 13 shows the output spectrum of the white light emitting pcLED of Example 4, which was prepared by coating a blue LED with the green phosphor of Example 3 and a red phosphor.

Figure 14 shows the color gamut of the white emitting pcLED of Example 4 displayed in a CIE 1931 chromaticity diagram.

## DETAILED DESCRIPTION

The following detailed description should be read with reference to the drawings, in which identical reference numbers refer to like elements throughout the different figures. The drawings, which are not necessarily to scale, depict selective embodiments and are not intended to limit the scope of the invention. The detailed description illustrates by way of example, not by way of limitation, the principles of the invention.

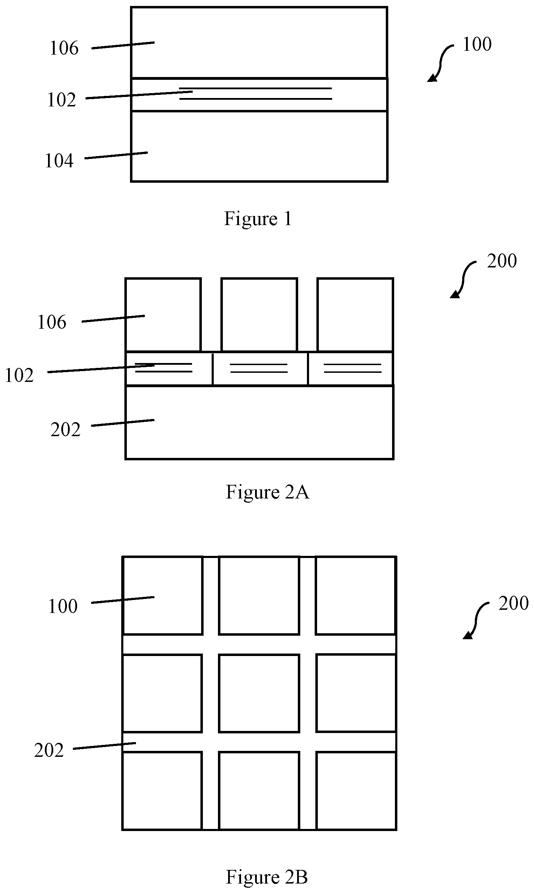

Figure 1 shows an example of an individual pcLED 100 comprising a light emitting semiconductor diode (LED) structure 102 disposed on a substrate 104, and a phosphor layer 106 (also referred to herein as a wavelength converting structure) disposed on the LED. Light emitting semiconductor diode structure 102 typically comprises an active region disposed between n-type and p-type layers. Application of a suitable forward bias across the diode structure results in emission of light from the active region. The wavelength of the emitted light is determined by the composition and structure of the active region.

The LED may be, for example, a III-Nitride LED that emits ultraviolet, blue, green, or red light. LEDs formed from any other suitable material system and that emit any other suitable wavelength of light may also be used. Other suitable material systems may include, for example, III-Phosphide materials, III-Arsenide materials, and II-VI materials.

Any suitable phosphor materials may be used, depending on the desired optical output and color specifications from the pcLED.

Figures 2A-2B show, respectively, cross-sectional and top views of an array 200 of pcLEDs 100 including phosphor pixels 106 disposed on a substrate 202. Such an array may include any suitable number of pcLEDs arranged in any suitable manner. In the illustrated example the array is depicted as formed monolithically on a shared substrate, but alternatively an array of pcLEDs may be formed from separate individual pcLEDs. Substrate 202 may optionally comprise CMOS circuitry for driving the LED and may be formed from any suitable materials.

Although Figures 2A-2B show a three-by-three array of nine pcLEDs, such arrays may include for example tens, hundreds, or thousands of LEDs. Individual LEDs (pixels) may have widths (e.g., side lengths) in the plane of the array, for example, less than or equal to 1 millimeter (mm), less than or equal to 500 microns, less than or equal to 100 microns, or less than or equal to 50 microns. LEDs in such an array may be spaced apart from each other by streets or lanes having a width in the plane of the array of, for example, hundreds of microns, less than or equal to 100 microns, less than or equal to 50 microns, less than or equal to 10 microns, or less than or equal to 5 microns. Although the illustrated examples show rectangular pixels arranged in a symmetric matrix, the pixels and the array may have any suitable shape or arrangement.

LEDs having dimensions in the plane of the array (e.g., side lengths) of less than or equal to about 50 microns are typically referred to as microLEDs, and an array of such microLEDs may be referred to as a microLED array.

An array of LEDs, or portions of such an array, may be formed as a segmented monolithic structure in which individual LED pixels are electrically isolated from each other by trenches and/or insulating material, but the electrically isolated segments remain physically connected to each other by portions of the semiconductor structure.

The individual LEDs in an LED array may be individually addressable, may be addressable as part of a group or subset of the pixels in the array, or may not be addressable. Thus, light emitting pixel arrays are useful for any application requiring or benefiting from fine-grained intensity, spatial, and temporal control of light distribution. These applications may include, but are not limited to, precise special patterning of emitted light from pixel blocks or individual pixels. Depending on the application, emitted light may be spectrally distinct, adaptive over time, and/or environmentally responsive. Such light emitting pixel arrays may provide pre-programmed light distribution in various intensity, spatial, or temporal patterns. The emitted light may be based at least in part on received sensor data and may be used for optical wireless communications. Associated electronics and optics may be distinct at a pixel, pixel block, or device level.

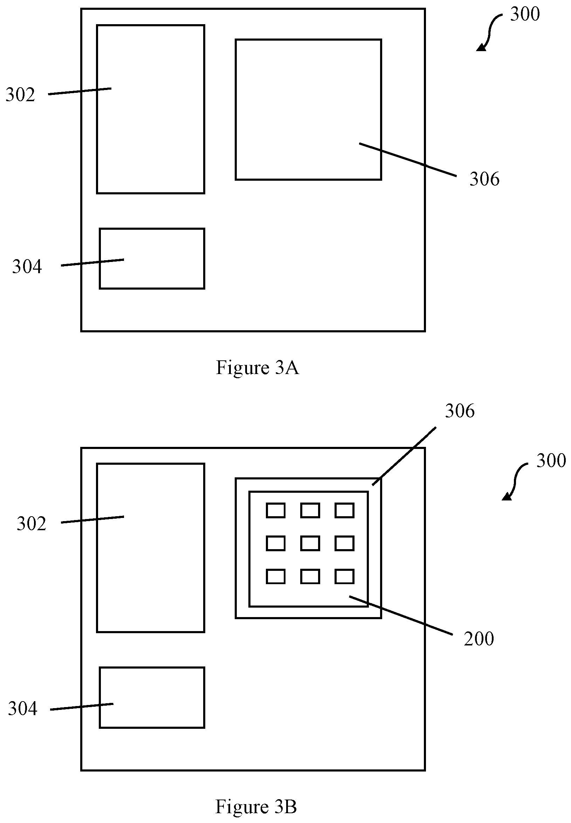

As shown in Figures 3A-3B, a pcLED array 200 may be mounted on an electronics board 300 comprising a power and control module 302, a sensor module 304, and an LED attach region 306. Power and control module 302 may receive power and control signals from external sources and signals from sensor module 304, based on which power and control module 302 controls operation of the LEDs. Sensor module 304 may receive signals from any suitable sensors, for example from temperature or light sensors. Alternatively, pcLED array 200 may be mounted on a separate board (not shown) from the power and control module and the sensor module.

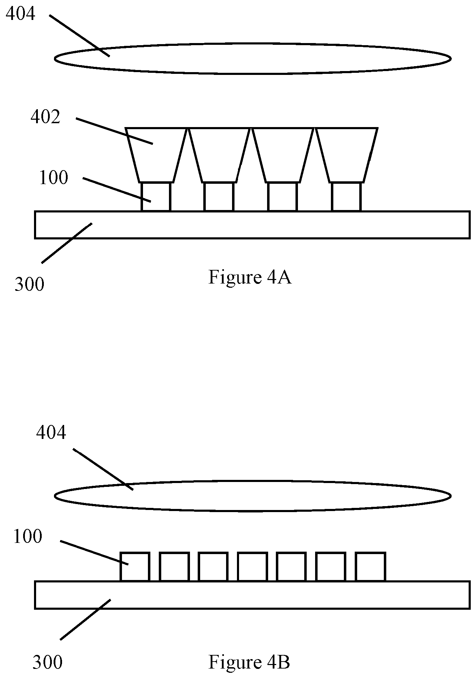

Individual pcLEDs may optionally incorporate or be arranged in combination with a lens or other optical element located adjacent to or disposed on the phosphor layer. Such an optical element, not shown in the figures, may be referred to as a "primary optical element". In addition, as shown in Figures 4A-4B a pcLED array 200 (for example, mounted on an electronics board 300) may be arranged in combination with secondary optical elements such as waveguides, lenses, or both for use in an intended application. In Figure 4A, light emitted by pcLEDs 100 is collected by waveguides 402 and directed to projection lens 404. Projection lens 404 may be a Fresnel lens, for example. This arrangement may be suitable for use, for example, in automobile headlights. In Figure 4B, light emitted by pcLEDs 100 is collected directly by projection lens 404 without use of intervening waveguides. This arrangement may be particularly suitable when pcLEDs can be spaced sufficiently close to each other and may also be used in automobile headlights as well as in camera flash applications. A microLED display application may use similar optical arrangements to those depicted in Figures 4A-4B, for example. Generally, any suitable arrangement of optical elements may be used in combination with the LED arrays described herein, depending on the desired application.

An array of independently operable LEDs may be used in combination with a lens, lens system, or other optical system (e.g., as described above) to provide illumination that is adaptable for a particular purpose. For example, in operation such an adaptive lighting system may provide illumination that varies by color and/or intensity across an illuminated scene or object and/or is aimed in a desired direction. A controller can be configured to receive data indicating locations and color characteristics of objects or persons in a scene and based on that information control LEDs in an LED array to provide illumination adapted to the scene. Such data can be provided for example by an image sensor, or optical (e.g., laser scanning) or non-optical (e.g., millimeter radar) sensors. Such adaptive illumination is increasingly important for automotive, mobile device camera, VR, and AR applications.

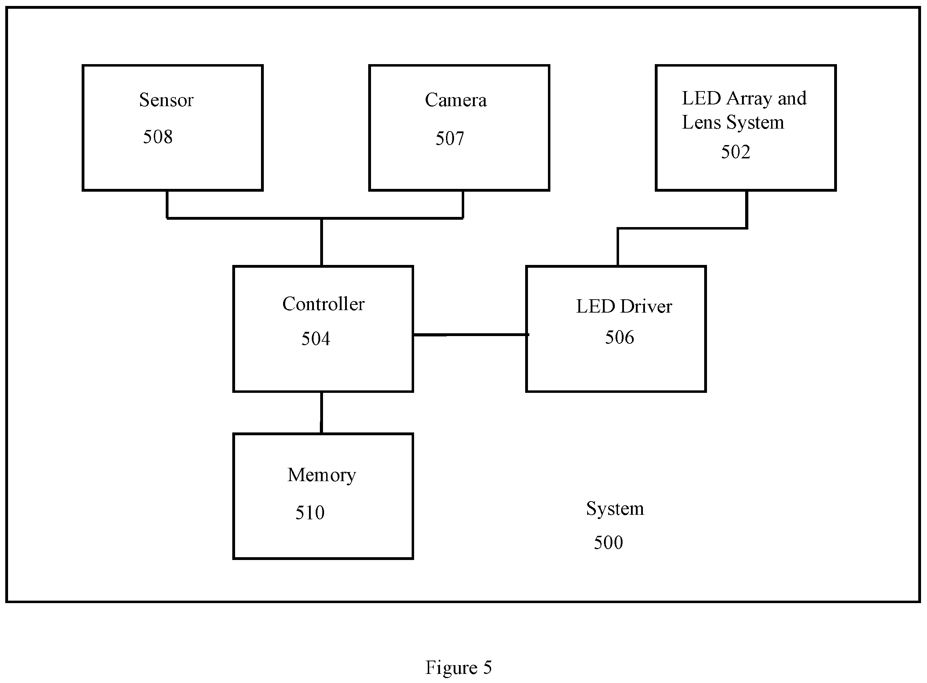

Figure 5 schematically illustrates an example camera flash system 500 comprising an LED array and lens system 502, which may be similar or identical to the systems described above. Flash system 500 also comprises an LED driver 506 that is controlled by a controller 504, such as a microprocessor. Controller 504 may also be coupled to a camera 507 and to sensors 508 and operate in accordance with instructions and profiles stored in memory 510. Camera 507 and adaptive illumination system 502 may be controlled by controller 504 to match their fields of view.

Sensors 508 may include, for example, positional sensors (e.g., a gyroscope and/or accelerometer) and/or other sensors that may be used to determine the position, speed, and orientation of system 500. The signals from the sensors 508 may be supplied to the controller 504 to be used to determine the appropriate course of action of the controller 504 (e.g., which LEDs are currently illuminating a target and which LEDs will be illuminating the target a predetermined amount of time later).

In operation, illumination from some or all pixels of the LED array in 502 may be adjusted - deactivated, operated at full intensity, or operated at an intermediate intensity. Beam focus or steering of light emitted by the LED array in 502 can be performed electronically by activating one or more subsets of the pixels, to permit dynamic adjustment of the beam shape without moving optics or changing the focus of the lens in the lighting apparatus.

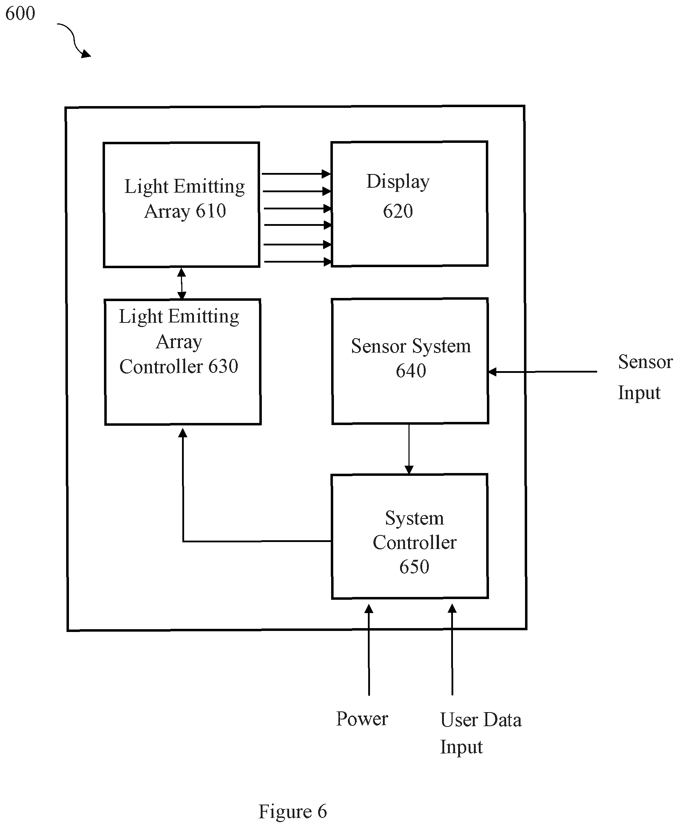

Figure 6 schematically illustrates an example display (e.g., AR/VR/MR) system 600 that includes an adaptive light emitting array 610, display 620, a light emitting array controller 630, sensor system 640, and system controller 650. Control input is provided to the sensor system 640, while power and user data input is provided to the system controller 650. In some embodiments modules included in system 600 can be compactly arranged in a single structure, or one or more elements can be separately mounted and connected via wireless or wired communication. For example, the light emitting array 610, display 620, and sensor system 640 can be mounted on a headset or glasses, with the light emitting controller and/or system controller 650 separately mounted.

The light emitting array 610 may include one or more adaptive light emitting arrays, as described above, for example, that can be used to project light in graphical or object patterns that can support AR/VR/MR systems. In some embodiments, arrays of microLEDs can be used.

System 600 can incorporate a wide range of optics in adaptive light emitting array 610 and/or display 620, for example to couple light emitted by adaptive light emitting array 610 into display 620.

Sensor system 640 can include, for example, external sensors such as cameras, depth sensors, or audio sensors that monitor the environment, and internal sensors such as accelerometers or two or three axis gyroscopes that monitor an AR/VR/MR headset position. Other sensors can include but are not limited to air pressure, stress sensors, temperature sensors, or any other suitable sensors needed for local or remote environmental monitoring. In some embodiments, control input can include detected touch or taps, gestural input, or control based on headset or display position.

In response to data from sensor system 640, system controller 650 can send images or instructions to the light emitting array controller 630. Changes or modification to the images or instructions can also be made by user data input, or automated data input as needed. User data input can include but is not limited to that provided by audio instructions, haptic feedback, eye or pupil positioning, or connected keyboard, mouse, or game controller.

As summarized above, this specification discloses nitridosilicate phosphors characterized by the formula $AE_{1-x-y-u}A_{y+u}Be_{1-y-z-v}B_{y+z+v}Si_{1-z}Al_zO_{1-v}N_{2+v}:Eu_x,Ce_u$, where $AE$ = Ba, Sr, Ca, Mg; $A$ = Li, Na, K, Rb; $0 \leq x \leq 0.1$; $0 \leq u \leq 0.1$; $0 < (x + u)$; $0 \leq y \leq 1$; $0 \leq z \leq 1$; $(y + z + v) \leq 1$; and $(x + y + u) \leq 1$. These phosphors may show peak photoluminescent emission from, for example, 500 nm - 600 nm, or 520 nm - 530 nm, with a FWHA of $\leq$ 55 nm, $\leq$ 50 nm, or $\leq$ 45 nm, for example. These phosphors may be used in pcLEDs used, for example, in displays and illumination.

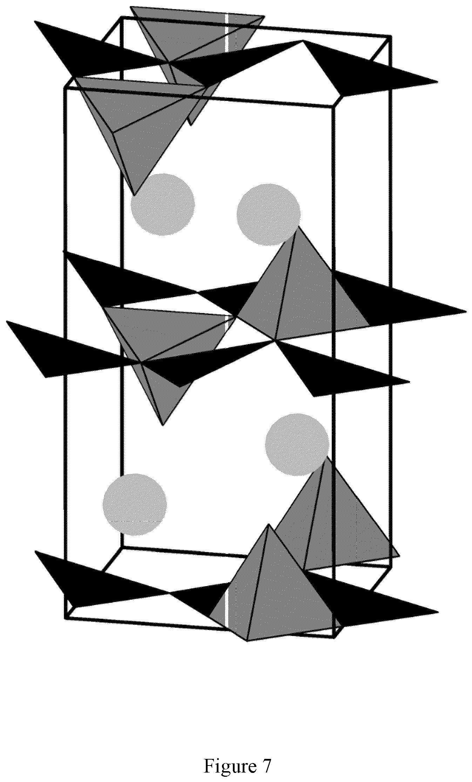

The oxonitridoberyllosilicate $BaBeSiON_2$ crystallizes in the orthorhombic space group $Ama2$ (no. 40) with lattice parameters $a$ = 5.6366(3), $b$ = 11.6363(7) and $c$ = 4.9295(3). Figure 7 shows its crystal structure, with Ba atoms shown as grey spheres, [BeN3] units shown as black triangles, and [SiON3] units shown as grey tetrahedra.

The crystal structure is closely related to $AE[Si_2O_2N_2]$-type oxonitridosilicates, especially $BaSi_2O_2N_2$. BaBe-$SiON_2$ exhibits $[BeSiON_2]^{2-}$ layers built by alternating chains of condensed trigonal planar $[BeN_3]^{7-}$ units and $[SiON_3]^{7-}$

tetrahedra. The tetrahedral chains show a strictly alternating UDUD... sequence. Every other $[SiON_3]^{7-}$ tetrahedron in $BaSi_2O_2N_2$ is replaced by a $[BeN_3]^{7-}$ unit in $BaBeSiON_2$.

Barium ions in $BaBeSiON_2$ are found in between the $[BeSiON_2]^{2-}$ layers, seven fold coordinated by four O and three N atoms forming a distorted pentagonal bipyramid.

Table 1 below provides crystallographic data for $BaBeSiON_2$.

Table 1

| Formula mass / g*mol$^{-1}$ | 218.46 |
|---|---|
| Crystal system | Orthorhombic |
| Space group | *Ama*2 |
| Cell parameters / Å | *a* = 5.6366(3) *b* = 11.6363(7) *c* = 4.9295(3) |
| V / Å$^3$ | 323.32(3) |
| Formula units Z / cell | 4 |
| X-ray density / g*cm$^{-3}$ | 2.244 |
| Abs. coefficient μ / mm$^{-1}$ | 6.208 |

Table 2 below provides atomic coordinates and equivalent displacement parameters of $BaBeSiON_2$.

Table 2: [a]

| Atom | Wyckoff position | x | y | z | U$_{eq}$ / Å$^3$ |
|---|---|---|---|---|---|
| Ba | 4b | 1/4 | 0.28252(3) | 0.04116(18) | 0.00697(6) |
| Si | 4b | 1/4 | 0.05603(16) | 0.4959(5) | 0.0030(3) |
| O | 4b | 1/4 | 0.1982(4) | 0.548(4) | 0.0089(6) |
| N1 | 4a | 0 | 0 | 0.6558(15) | 0.0068(8) |
| N2 | 4b | 1/4 | 0.0300(7) | 0.1562(17) | 0.0072(8) |
| Be | 4a | 0 | 0 | 0.000(3) | 0.0077(13) |
| [a] e.s.d.'s (estimated standard deviations) in parentheses | | | | | |

Table 3 below provides selected bond lengths (Å) of $BaBeSiON_2$.

Table 3:

| Bond name | |
|---|---|
| Ba-O | 2.638(14) |
| Ba-O | 2.663(14) |
| Ba-O | 2.8267(3) x2 |
| Ba-N1 | 2.9508(11) x2 |
| Ba-N2 | 2.990(6) |
| Si-O | 1.672(4) |
| Si-N1 | 1.742(3) x2 |
| Si-N2 | 1.717(6) |
| Be-N1 | 1.685(10) |
| Be-N2 | 1.642(5) x2 |

Synthesis and characterization of examples of the nitridosilicate phosphors described above are presented below.

**Example 1, synthesis of $Ba_{0.995}BeSiON_2:Eu_{0.005}$.** 50.8 mg barium amide, prepared amonothermally from barium metal (Alfa Aesar, 99.9%), 5.5 mg beryllium nitride, prepared by firing beryllium metal (ABCR, 99%) under nitrogen, 4.2 mg silicon (Alfa Aesar, 99.9%), 9.0 mg silicon oxide, and 0.3 mg europium fluoride (Sigma-Aldrich) are mixed in an agate mortar and fired at 1400 °C set temperature under nitrogen atmosphere in a radio frequency furnace for 5 hrs.

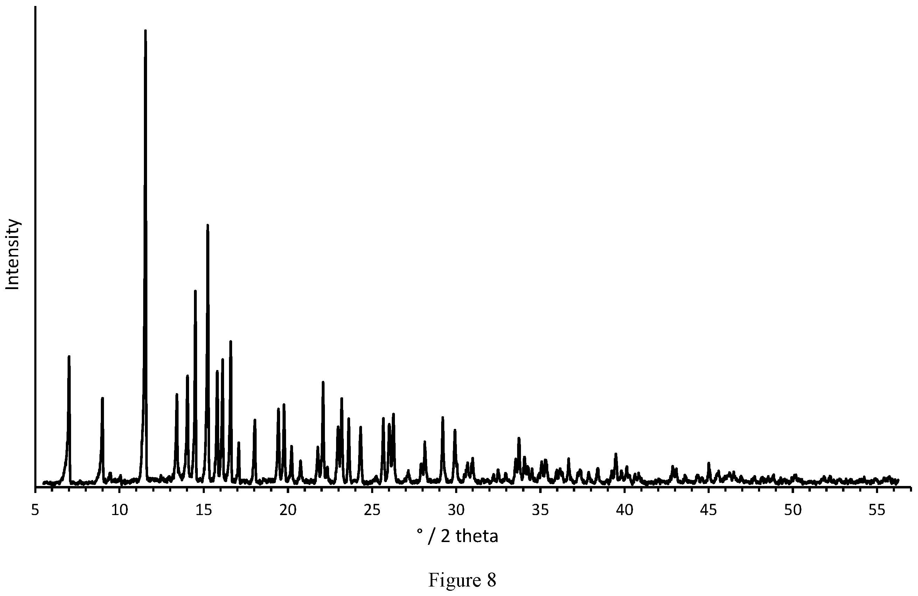

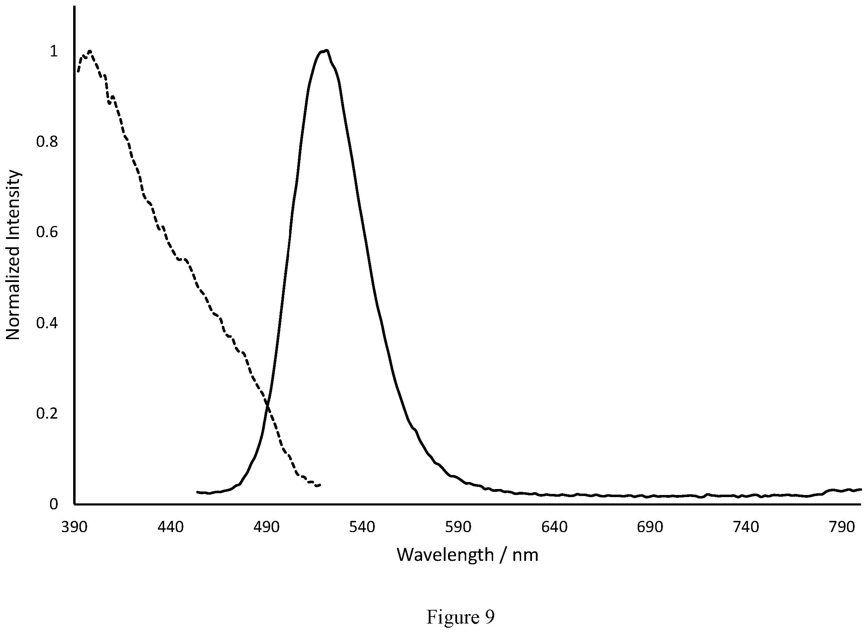

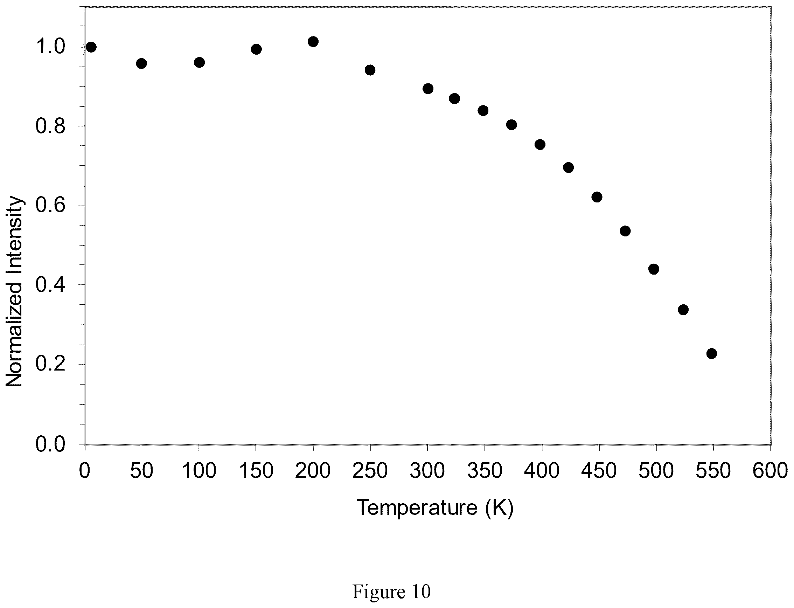

Figure 8 shows the XRD powder pattern of Example 1, which crystallizes in the orthorhombic crystal structure of $BaBeSiON_2$ with lattice parameters $a_0$ = 5.6366 Å, $b_0$ = 11.6363 Å and $c_0$ = 4.9295 Å. Figure 9 shows an excitation spectrum (dashed line, 530 nm monitoring) and an emission spectrum (solid line, 440 nm excitation) for Example 1. The material shows a peak emission at 522 nm with an emission half width of 45 nm if excited with 440 nm blue light. Figure 10 shows the thermal quenching behavior for Example 1 between 6K and 550K.

The elemental composition of $BaBeSiON_2$ was confirmed via energy-dispersive X-ray spectroscopy (EDS). Table 4 provides elemental analysis (EDS) for $BaBeSiON_2$ in atom%. Note that Be cannot be detected with EDS.

Table 4.

| Ba | Si | O | N |
|---|---|---|---|
| 19.42 | 19.14 | 21.65 | 39.80 |

**Example 2, synthesis of a doping concentration series of $Ba_{1-x}BeSiON_2:Eu_x$ (0.005 < x < 0.02).** 50.8 mg barium amide, prepared via ammonothermal synthesis from barium metal (Alfa Aesar, 99.9%), 5.5 mg beryllium nitride, prepared by firing beryllium metal (ABCR, 99%) under nitrogen, 4.2 mg silicon (Alfa Aesar, 99.9%), 9.0 mg silicon oxide, and various amounts of europium fluoride (0.3, 0.7, 1.4 mg respectively), are mixed in an agate mortar and fired at 1400 °C setting temperature under nitrogen in a radio frequency furnace for 5 hrs. The Europium concentrations correspond to values of doping-levels of 0.5%, 1% and 2%.

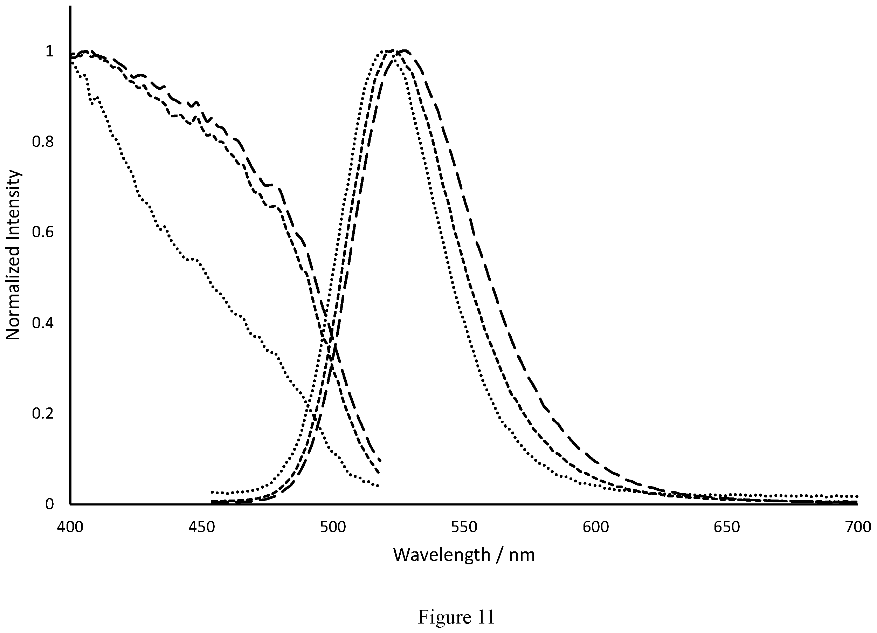

Figure 11 shows excitation spectra (dashed lines, 530 nm monitoring) and emission spectra (solid lines, 440 nm monitoring) for the series of materials prepared in Example 2. The powders of the doping concentration series show peak emissions ranging from at 522 to 528 nm with FWHM ranging from 45-54 nm if excited with 440 nm blue light.

**Example 3, synthesis of $Ba_{0.9925}BeSiON_2:Eu_{0.0075}$.** 83.6 mg barium hydride (Materion, 99.5%), 15.0 mg beryllium oxide (Alfa Aesar, 99.95%), 28.1 mg silicon nitride (Ube Industries, SN-E10), 0.9 mg europium fluoride (Sigma-Aldrich), and 1.3 mg barium fluoride (abcr, 99.999 %) are mixed in an agate mortar and fired at 1400°C setting temperature under nitrogen in a radio frequency furnace for 5 hrs.

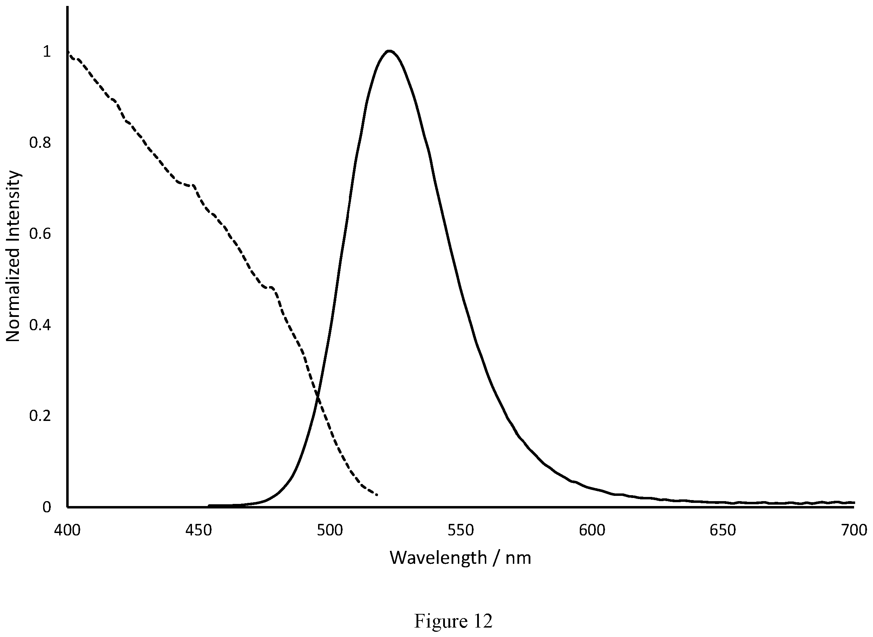

Figure 12 shows an excitation spectrum (538 nm monitoring, dotted line) and an emission spectrum (420 nm excitation, solid line) for Example 3. The doping level of ~0.75% Eu results in narrow-band green emission with FWHM of 46nm at ~522nm maximum emission.

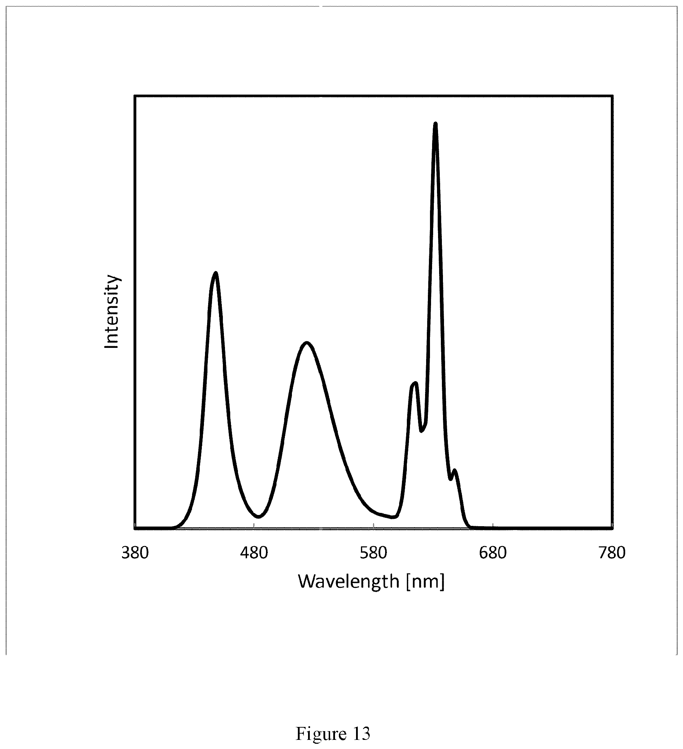

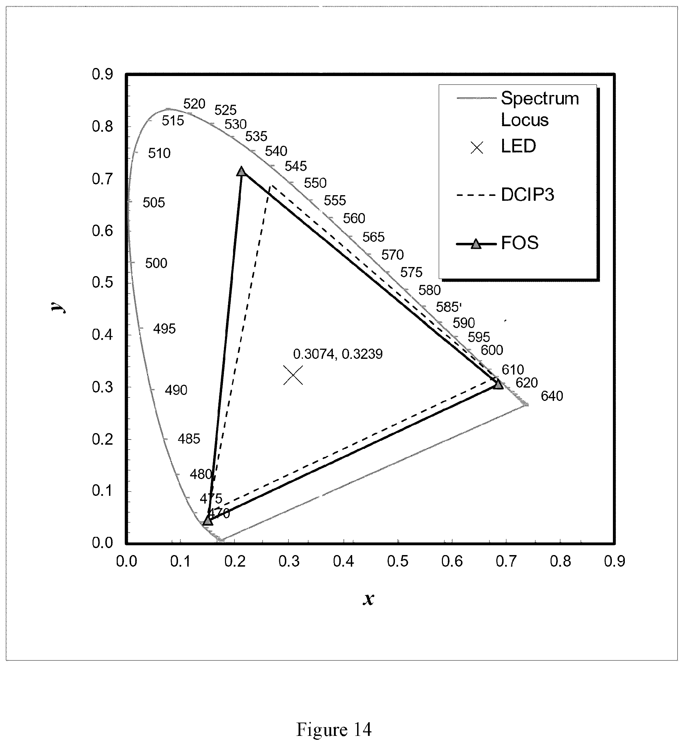

**Example 4, pcLED comprising $Ba_{0.9925}BeSiON_2:Eu_{0.0075}$.** A white light emitting pcLEDs was prepared by coating a blue LED with the green phosphor of Example 3 ($Ba_{0.9925}BeSiON_2:Eu_{0.0075}$ and red emitting KSIF:Mn ($K_2SiF_6:Mn^{4+}$). Figure 13 shows its output spectrum. Figure 14 shows the color gamut of this white pcLED (FOS - full line) displayed in a CIE 1931 chromaticity diagram and compared to DCIP3 gamut. The displayed gamut achieves 108.3% compared to NTSC standard and 109.0% compared to DCI P3 gamut.

**Example 5, synthesis** of **$Ba_{0.9925}BeSiON_2:Eu_{0.0075}$.** 83.6 mg barium hydride (Materion, 99.5%), 15.0 mg beryllium oxide (Alfa Aesar, 99.95%), 28.1 mg silicon nitride (Ube Industries, SN-E10), 0.9 mg europium fluoride (Sigma-Aldrich), 1.3 mg barium fluoride (abcr, 99.999 %), and 1.4 mg $Li_3N$ (Materion, 99.5%) are mixed in an agate mortar and fired at 1375°C setting temperature under nitrogen in a radio frequency furnace for 3 hrs. It is observed that addition of $Li_3N$ allows the firing time to be reduced and improves phase formation and crystallization of the target compound.

This disclosure is illustrative and not limiting. Further modifications will be apparent to one skilled in the art in light of this disclosure and are intended to fall within the scope of the appended claims.

**Claims**

1.   A photoluminescent composition **characterized by**:

$$AE_{1-x-y-u}A_{y+u}Be_{1-y-z-v}B_{y+z+v}Si_{1-z}Al_zO_{1-v}N_{2+v}:Eu_x,Ce_u;$$

AE = Ba, Sr, Ca, Mg;

A = Li, Na, K, Rb;

$$0 \leq x \leq 0.1;$$

$$0 \leq u \leq 0.1;$$

$$0 < (x + u);$$

$$0 \leq y \leq 1;$$

$$0 \leq z \leq 1;$$

$$(y + z + v) \leq 1;$$

and

$$(x + y + u) \leq 1.$$

2. The photoluminescent composition of claim 1, wherein $(y + z + v) > 0$.

3. The photoluminescent composition of claim 2, wherein $z > 0$.

4. The photoluminescent composition of claim 1 wherein $x > 0$ and $u > 0$.

5. The photoluminescent composition of claim 1, wherein $(y + u) > 0$.

6. The photoluminescent composition of claim 1 **characterized by**

$$Ba_{0.9}Sr_{0.05}K_{0.015}Be_{0.5}B_{0.5}Si_{0.5}Al_{0.5}ON_2:Eu_{0.02},Ce_{0.015}.$$

7. The photoluminescent composition of claim 1 **characterized by**

$$Ba_{0.48}Na_{0.5}Be_{0.5}B_{0.5}SiON_2:Eu_{0.02}.$$

8. The photoluminescent composition of claim A1 **characterized by**

$$Ba_{0.5}Sr_{0.49}Be_{0.5}B_{0.5}SiO_{0.5}N_{2.5}:Eu_{0.01}.$$

9. The photoluminescent composition of claim 1 **characterized by** $Sr_{0.99}BSiN_3:Eu_{0.01}.$

10. The photoluminescent composition of claim 1 **characterized by**:

$$Ba_{1-x}BeSiON_2:Eu_x;$$

and

$$0 < x \leq 0.10.$$

**11.** The photoluminescent composition of claim 10, wherein $0 < x \leq 0.04$.

**12.** The photoluminescent composition of claim 10, wherein $0.005 \leq x \leq 0.02$.

**13.** The photoluminescent composition of claim 10, wherein $x = 0.01$.

**14.** The photoluminescent composition of claim 10, wherein $x = 0.005$.

**15.** The photoluminescent composition of claim 10, wherein $x = 0.0075$.

**Patentansprüche**

**1.** Eine photolumineszente Zusammensetzung, **gekennzeichnet durch**:

$$AE_{1-x-y-u}A_{y+u}Be_{1-y-z-v}B_{y+z+v}Si_{1-z}Al_zO_{1-v}N_{2+v}:Eu_x,Ce_u;$$

$$AE = Ba, Sr, Ca, Mg;$$

$$A = Li, Na, K, Rb;$$

$$0 \leq x \leq 0,1;$$

$$0 \leq u \leq 0,1;$$

$$0 < (x + u);$$

$$0 \leq y \leq 1;$$

$$0 \leq z \leq 1;$$

$$(y + z + v) \leq 1;$$

und

$$(x + y + u) \leq 1.$$

**2.** Die photolumineszente Zusammensetzung nach Anspruch 1, wobei $(y + z + v) > 0$ ist.

**3.** Die photolumineszente Zusammensetzung nach Anspruch 2, wobei $z > 0$ ist.

**4.** Die photolumineszente Zusammensetzung nach Anspruch 1, wobei $x > 0$ und $u > 0$ ist.

**5.** Die photolumineszente Zusammensetzung nach Anspruch 1, wobei $(y + u) > 0$ ist.

**6.** Die photolumineszente Zusammensetzung nach Anspruch 1, **gekennzeichnet durch**

$$Ba_{0,9}Sr_{0,05}K_{0,015}Be_{0,5}B_{0,5}Si_{0,5}Al_{0,5}ON_2:Eu_{0,02},Ce_{0,015}.$$

**7.** Die photolumineszente Zusammensetzung nach Anspruch 1, **gekennzeichnet durch**

$Ba_{0,48}Na_{0,5}Be_{0,5}B_{0,5}SiON_2{:}Eu_{0,02}.$

8. Die photolumineszente Zusammensetzung nach Anspruch 1, **gekennzeichnet durch**

$Ba_{0,5}Sr_{0,49}Be_{0,5}B_{0,5}SiO_{0,5}N_{2,5}{:}Eu_{0,01}.$

9. Die photolumineszente Zusammensetzung nach Anspruch 1, **gekennzeichnet durch**

$Sr_{0,99}BSiN_3{:}Eu_{0,01}.$

10. Die photolumineszente Zusammensetzung nach Anspruch 1, **gekennzeichnet durch**:

$Ba_{1-x}BeSiON_2{:}Eu_x;$

und

$$0 < x \le 0,10.$$

11. Die photolumineszente Zusammensetzung nach Anspruch 10, wobei $0 < x \le 0,04$.

12. Die photolumineszente Zusammensetzung nach Anspruch 10, wobei $0,005 \le x \le 0,02$.

13. Die photolumineszente Zusammensetzung nach Anspruch 10, wobei x = 0,01 ist.

14. Die photolumineszente Zusammensetzung nach Anspruch 10, wobei x = 0,005 ist.

15. Die photolumineszente Zusammensetzung nach Anspruch 10, wobei x = 0,0075 ist.

**Revendications**

1. Une composition photoluminescente **caractérisée par** :

$AE_{1-x-y-u}A_{y+u}Be_{1-y-z-v}B_{y+z+v}Si_{1-z}Al_zO_{1-v}N_{2+v}{:}Eu_x,Ceu;$

AE = Ba, Sr, Ca, Mg;

A = Li, Na, K, Rb;

$$0 \le x \le 0,1;$$

$$0 \le u \le 0,1;$$

$$0 < (x + u);$$

$$0 \le y \le 1;$$

$$0 \le z \le 1;$$

$$(y + z + v) \leq 1;$$

et

$$(x + y + u) \leq 1.$$

2. Composition photoluminescente selon la revendication 1, dans laquelle (y + z + v) > 0.

3. Composition photoluminescente selon la revendication 2, dans laquelle z > 0.

4. Composition photoluminescente selon la revendication 1, dans laquelle x > 0 et u > 0.

5. Composition photoluminescente selon la revendication 1, dans laquelle (y + u) > 0.

6. Composition photoluminescente selon la revendication 1, **caractérisée par**

$$Ba_{0,9}Sr_{0,05}K_{0,015}Be_{0,5}B_{0,5}Si_{0,5}Al_{0,5}ON_2{:}Eu_{0,02},Ce_{0,015}.$$

7. Composition photoluminescente selon la revendication 1, **caractérisée par**

$$Ba0,48Na0,5Be0,5B0,5SiON2{:}Eu0,02.$$

8. La composition photoluminescente selon la revendication 1 **caractérisée par** $Ba_{0,5}Sr_{0,49}Be_{0,5}B_{0,5}SiO_{0,5}N_{2,5}{:}Eu_{0,01}.$

9. Composition photoluminescente selon la revendication 1, **caractérisée par** $Sr_{0,99}BSiN_3{:}Eu_{0,01}.$

10. Composition photoluminescente selon la revendication 1, **caractérisée par**:

$$Ba_{1-x}BeSiON_2{:}Eu_x\ ;$$

et

$$0 < x \leq 0{,}10.$$

11. Composition photoluminescente selon la revendication 10, dans laquelle $0 < x \leq 0{,}04$.

12. Composition photoluminescente selon la revendication 10, dans laquelle $0{,}005 \leq x \leq 0{,}02$.

13. Composition photoluminescente selon la revendication 10, dans laquelle x = 0,01.

14. Composition photoluminescente selon la revendication 10, dans laquelle x = 0,005.

15. Composition photoluminescente selon la revendication 10, dans laquelle x = 0,0075.

Figure 1

Figure 2A

Figure 2B

302

306

300

Figure 3A

306

300

302

200

304

Figure 3B

404

402

100

300

Figure 4A

404

100

300

Figure 4B

```
┌─────────────────────────────────────────────────────────────────────────────────┐
│                                                                                   │
│   ┌──────────────┐      ┌──────────────┐         ┌──────────────────┐            │
│   │    Sensor    │      │    Camera    │         │  LED Array and   │            │
│   │     508      │      │     507      │         │   Lens System    │            │
│   │              │      │              │         │       502        │            │
│   └───────┬──────┘      └──────┬───────┘         └─────────┬────────┘            │
│           └──────────┬─────────┘                           │                      │
│                      │                                     │                      │
│              ┌───────┴──────┐                   ┌──────────┴───────┐             │
│              │  Controller  │                   │   LED Driver     │             │
│              │     504      ├───────────────────┤      506         │             │
│              └───────┬──────┘                   └──────────────────┘             │
│                      │                                                            │
│              ┌───────┴──────┐                                                     │
│              │    Memory    │                     System                          │
│              │     510      │                      500                            │
│              └──────────────┘                                                     │
│                                                                                   │
└─────────────────────────────────────────────────────────────────────────────────┘
```

Figure 5

600

Figure 6

Figure 7

EP 4 444 820 B1

Figure 8

Figure 9

Figure 10

EP 4 444 820 B1

Figure 11

Figure 12

Figure 13

Figure 14

**EP 4 444 820 B1**

**Patent documents cited in the description**

- US 63287797

- US 2010277054 A1